# EUROPÄISCHE PATENTANMELDUNG

(11) **EP 1 515 375 A2**
(43) Veröffentlichungstag der Anmeldung: **16.03.2005**
(21) Anmeldenummer: 04021280.5
(22) Anmeldetag: 08.09.2004
(51) Int. Cl.: H01L 35/32

(54) **Vorrichtung für die Erzeugung elektrischer Energie**

(30) Priorität: 15.09.2003 DE 10342655
(71) Anmelder: Müller-Werth, Bernhard, 66280 Sulzbach (DE); von Puttkamer, Ewald, Prof. Dr., 67663 Kaiserslautern (DE)
(72) Erfinder: Müller-Werth, Bernhard, 66280 Sulzbach (DE); von Puttkamer, Ewald, Prof. Dr., 67663 Kaiserslautern (DE)
(74) Vertreter: Bernhardt, Reinold, Dr. Dipl.Phys.

(57) **Zusammenfassung**

Die Erfindung betrifft eine Vorrichtung für die Erzeugung elektrischer Energie, mit einer Reihenanordnung aus einer Vielzahl von Thermoelementen, die jeweils ein erstes Leiterstück (19), ein mit dem ersten Leiterstück verbundenes zweites Leiterstück (1;2) und ein drittes Leiterstück (20), das mit dem zweiten Leiterstück auf einer dem ersten Leiterstück gegenüberliegenden Seite verbunden ist, aufweisen, wobei das Leitermaterial der ersten und dritten Leiterstücke (19,20) unterschiedlich zum Leitermaterial der zweiten Leiterstücke (1:2) ist, die ersten Leiterstücke (19) mit einer Wärmequelle (9) und die dritten Leiterstücke (20) mit einer Wärmesenke (11) verbunden sind und in der Reihenanordnung abwechselnd die ersten und dritten Leiterstücke (19,20) aufeinander folgender Thermoelemente einander zugewandt sind. Gemäß der Erfindung sind die in der Reihenanordnung einander zugewandten Leiterstücke jeweils elektrisch miteinander verbunden und die zweiten Leiterstücke abwechselnd durch einen p-leitenden (1) und einen n-leitenden (2) Halbleiter gebildet.

## Beschreibung

Die Erfindung betrifft eine Vorrichtung für die Erzeugung elektrischer Energie, mit einer Reihenanordnung aus einer Vielzahl von Thermoelementen, die jeweils ein erstes Leiterstück, ein mit dem ersten Leiterstück verbundenes zweites Leiterstück und ein drittes Leiterstück, dass mit dem zweiten Leiterstück auf einer dem ersten Leiterstück gegenüberliegenden Seite verbunden ist, aufweisen, wobei das Leitermaterial der ersten und dritten Leiterstücke unterschiedlich zum Leitermaterial der zweiten Leiterstücke ist, die ersten Leiterstücke mit einer Wärmequelle und die dritten Leiterstücke mit einer Wärmesenke verbunden und in der Reihenordnung abwechselnd die ersten und dritten Leiterstücke der aufeinanderfolgenden Thermoelemente einander zugewandt sind.

Eine solche, Wärme in elektrische Energie umwandelnde Thermobatterie ist aus der DE 102 00 407 A1 bekannt. Die Thermoelemente dieser Thermobatterien sind parallel geschaltet.

Der vorliegenden Erfindung liegt die Aufgabe zugrunde, die Leistungsfähigkeit einer solchen Thermobatterie zu verbessern.

Die diese Aufgabe lösende Vorrichtung nach der Erfindung ist dadurch gekennzeichnet, dass die in der Reihenanordnung einander zugewandten Leiterstücke jeweils elektrisch miteinander verbunden und die zweiten Leiterstücke abwechselnd durch einen p-leitenden und einen n-leitenden Halbleiter gebildet sind.

Diese Thermobatterie nach der Erfindung, welche Halbleiter aufweisende Thermoelemente in Reihenschaltung verwendet, kann gegenüber herkömmlichen Batterien der Eingangs erwähnten Art höhere elektrische Spannungen abgeben.

In vorteilhafter Ausgestaltung der Erfindung sind die ersten und die dritten Leiterstücke durch Folien oder Platten gebildet und die Halbleiter jeweils an einander gegenüberliegenden Kontaktflächen mit den Folien bzw. Platten verbunden, wobei eine Stapelanordnung solcher Folien oder Platten gebildet ist.

Die beiden einander zugewandten ersten und dritten Leiterstücke können jeweils direkt durch eine mit der Wärmequelle bzw. Wärmesenke verbundene, vorzugsweise einzige, Wärmeleitplatte gebildet sein oder die Folien bzw. Platten liegen auf ihren den Halbleitern abgewandten Seite gegen eine solche Wärmeleitplatte an.

Vorzugsweise ist zwischen den Folien oder Platten jeweils eine Vielzahl von n-leitenden bzw. p-leitenden Halbleitern angeordnet. Durch eine solche Parallelschaltung vieler Thermoelemente verringert sich der Innenwiderstand der Thermobatterie. Entsprechend erhöht sich die elektrische Leistung.

Vorzugsweise stehen die Wärmeleitplatten mit einem über die Stapelanordnung hinaus vorstehenden Rand mit der Wärmequelle bzw. Wärmesenke im Kontakt, wobei zwischen der Stapelanordnung und der Wärmequelle bzw. Wärmesenke zweckmäßig eine sowohl elektrisch als auch thermisch isolierende Schicht angeordnet ist, welche von den Platten durchstoßen wird bzw. in oder an welcher die Platten enden.

Vorzugsweise strömt innerhalb der Platten ein wärmetransportierendes Medium, um durch Wärmekonvektion eine möglichst effektive Wärmeübertragung zu erzielen.

Die Wärmequelle und Wärmesenke weist jeweils einen von wärmezu- bzw. -abführendem Medium durchströmten Behälter auf, in welchen in einer Ausführungsform die betreffenden Wärmeleitplatten hineinragen. Vorzugsweise durchströmt das Medium den Behälter parallel zur Oberfläche der Wärmeleitplatten. Ein in den Behälter ragender Teil der Wärmeleitplatten ist elektrisch gegen das Medium und den Behälter isoliert. Alternativ könnten die Wärmeleitplatten an ihrem vorstehenden Ende mit Wärmeleitrohren umwunden sein.

Sowohl für die Wärmeleitrohre als auch die Wärmeleitplatten kommt das Heatpipe-Prinzip in Betracht.

Die Erfindung soll nun anhand eines Ausführungsbeispiels und der beiliegenden, sich auf dieses Ausführungsbeispiel beziehenden Zeichnungen näher erläutert werden. Es zeigen:
- Fig. 1: eine Schemadarstellung eines in einer Thermobatterie nach der Erfindung verwendeten thermoelektrischen Elements mit einem p-leitenden und einem n-leitenden Halbleiter,
- Fig. 2: eine Reihenschaltung von Elementen gemäß Fig. 1,
- Fig. 3: eine Elemente gemäß Fig. 1 und 2 verwendende Thermobatterie nach der Erfindung,
- Fig. 4 und 5: den Aufbau der Thermobatterie von Fig. 3 erläuternde Teildarstellungen, und
- Fig. 6: ein weiteres Ausführungsbeispiel für die Verbindung von Wärmeleitplatten mit einer Wärmeleitungsröhren aufweisenden Wärmesenke.

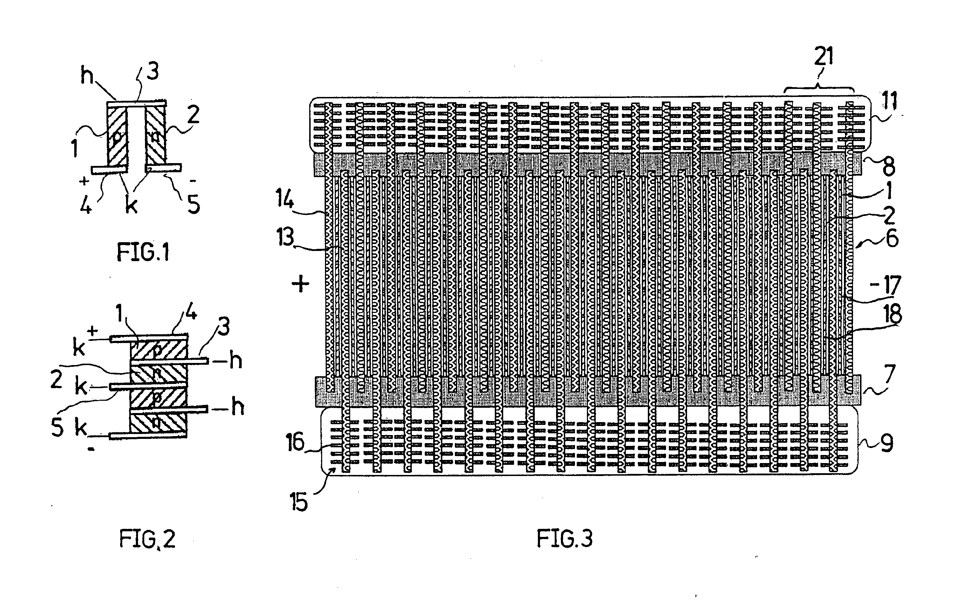

Gemäß Fig. 1 ist ein p-dotierter Halbleiter 1 über ein Leiterstück 3 mit einem n-dotierten Halbleiter 2 verbunden und an den dem Leiterstück 3 abgewandten Enden der Halbleiter ist jeweils ein Leiterstück 4 bzw. 5 angebracht. Liegt das Leiterstück 3 auf höherer Temperatur als die Leiterstücke 4 und 5, d.h., sind durch das Leiterstück 3 zu den Halbleitern heiße Kontakte (h) und durch die Leiterstücke 4 und 5 kalte Kontakte (k) gebildet, so herrscht entsprechend dem Temperaturunterschied zwischen den Leiterstücken 4 und 5 eine thermoelektrische Spannung. In einer solchen Elementarzelle gemäß Fig. 1 addieren sich die thermoelektrischen Spannungen der beiden, einen n-dotierten bzw. p-dotierten Halbleiter aufweisenden Grundelemente.

Gemäß Fig. 2 sind zwei solcher Elementarzellen in Reihe geschaltet, wobei das Leiterstück 5 ein Verbindungsstück zur zweiten Elementarzelle bildet und das Leiterstück 3 auf gegenüberliegenden Seiten Kontaktflächen zu den p- und n-dotierten Halbleitern 1 und 2 aufweist.

Die in Fig. 2 gezeigte Anordnung entspricht dem Grundaufbau einer in den Fig. 3 bis 5 gezeigten Thermobatterie.

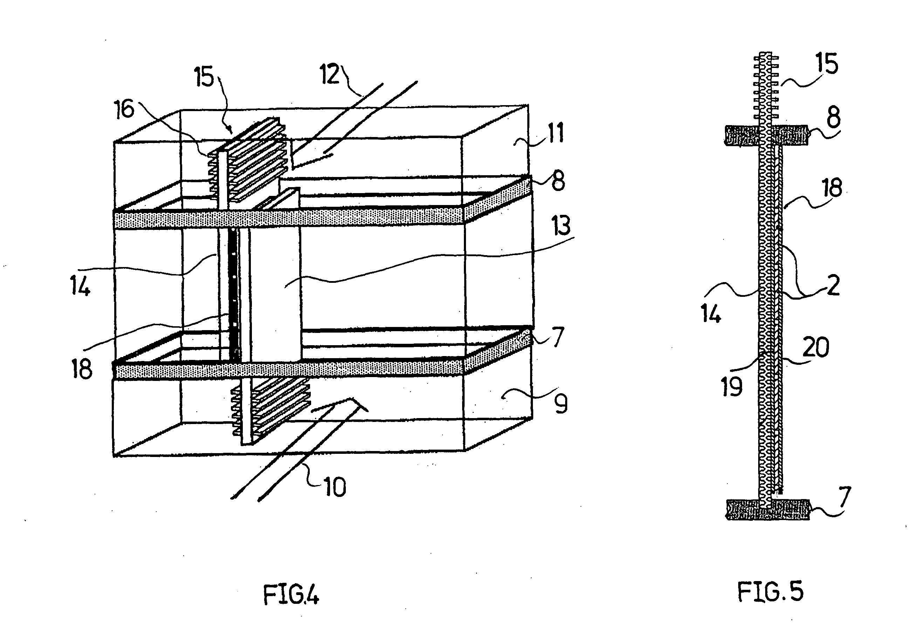

Eine gemäß Fig. 3 aus verschiedenen Platten gebildete Stapelanordnung 6 ist zwischen thermisch und elektrisch isolierenden Schichten 7 und 8 angeordnet. Auf der der Stapelanordnung abgewandten Seite grenzt an die Isolierschicht 7 ein Behälter 9, der gemäß Pfeil 10 (Fig. 4) von einer wärmezuführenden Flüssigkeit durchströmt wird, deren Temperatur z.B. 130°C beträgt. Die Isolierschicht 8 auf der gegenüberliegenden Seite der Stapelanordnung 6 grenzt an einen Behälter 11, der gemäß Pfeil 12 (Fig. 4) von einer wärmeabführenden Flüssigkeit durchströmt wird, deren Temperatur z.B. 80°C beträgt.

Bestandteil der Stapelanordnung 6 sind abwechselnd mit dem Behälter 9 und dem Behälter 11 verbundene Wärmeleitplatten 13 und 14, welche durch die betreffende Isolierschicht 7 bzw. 8 hindurchtreten und in der jeweils entfernter angeordneten Isolierschicht enden.

Die Wärmeleitplatten 13,14 führen Wärme nicht nur durch Wärmeleitung zu bzw. ab, sondern vor allem durch Wärmekonvektion, indem innerhalb der Platten ein wärmetransportierendes Medium strömt.

Ein jeweils in den Behälter 9,11 hineinragender Teil 15 der Wärmeleitplatten 13,14 ist elektrisch gegen das in den Behältern 9,11 parallel zu den Wärmeleitplatten strömende Medium isoliert und weist Rippen 16 zur Verbesserung des Wärmeübergangs zwischen den Platten und dem Medium auf.

Zwischen den Wärmeleitplatten 13,14 sind abwechselnd Lagen 17 mit p-leitenden Halbleitern 1 und Lagen 18 mit n-leitenden Halbleitern 2 angeordnet. Jede der Lagen 17,18 weist, als erste und dritte Leiterstücke, zwei Kupferfolien 19 und 20 auf, welche die Halbleiter 1 bzw. 2, als zweite Leiterstücke, zwischen sich einschließen. Die in Form dünner Platten ausgebildeten Halbleiter 1 und 2 sind über die Fläche der jeweiligen Lagen 17,18 verteilt, z.B. in einem quadratischen Raster. Zweckmäßig sind die Lagen 17,18 vorgefertigt, um die Montage der Thermobatterie zu vereinfachen.

In dem betreffenden Ausführungsbeispiel beträgt die jeweilige Dicke der Isolierschichten 10 cm, der Wärmeleitplatten 8 mm, der Halbleiter 1,2 1 mm und die Dicke der Kupferfolien 19,20 0,3 mm.

Im Betrieb der Thermobatterie werden die Behälter 9 und 11 durchströmt, wobei die mit den Behältern im Wärmekontakt stehenden Wärmeleitplatten 13,14 innerhalb der Stapelanordnung unterschiedliche Temperaturen annehmen. Jeweils eine Wärmeleitplatte 13 und eine Wärmeleitplatte 14 bilden mit zwei Lagen 16 und einer Lage 17 eine Einheit 21 mit einer Vielzahl von Thermoelementen in Parallelschaltung. In der Stapelanordnung ist wiederum eine Vielzahl solcher Einheiten in Reihe geschaltet. An den äußeren Platten der Stapelanordnung lässt sich eine entsprechend vervielfachte Thermospannung abgreifen.

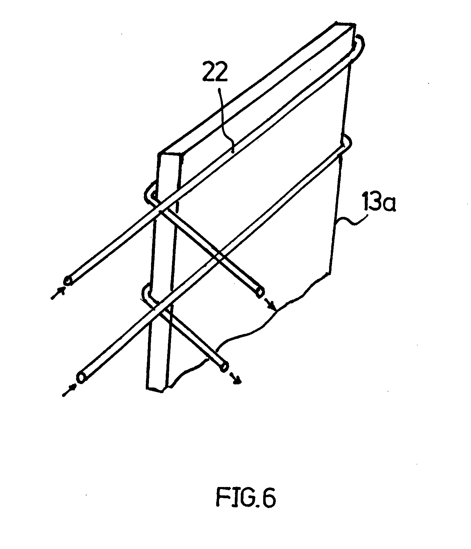

Es wird nun auf Fig. 6 Bezug genommen, wo eine Wärmeleitplatte 13a gezeigt ist, die an einem aus einer nicht gezeigten Stapelanordnung hervorstehenden Plattenende mit einem Bündel von Wärmeleitröhren 22 einmal umwunden ist. Von 25 Röhren sind der Einfachheit halber nur zwei gezeigt. Die Röhren sind parallel an einem Wärmebehälter angeschlossen. Insbesondere handelt es sich bei den Wärmeröhren 22 um Heatpipes.

## Patentansprüche

1. Vorrichtung für die Erzeugung elektrischer Energie, mit einer Reihenanordnung aus einer Vielzahl von Thermoelementen, die jeweils ein erstes Leiterstück (19), ein mit dem ersten Leiterstück verbundenes zweites Leiterstück (1 ;2) und ein drittes Leiterstück (20), dass mit dem zweiten Leiterstück (1;2) auf einer dem ersten Leiterstück (19) gegenüberliegenden Seite verbunden ist, aufweisen, wobei das Leitermaterial der ersten und dritten Leiterstücke (19, 20) unterschiedlich zum Leitermaterial der zweiten Leiterstücke (1;2) ist, die ersten Leiterstücke (19) mit einer Wärmequelle (9) und die dritten Leiterstücke (20) mit einer Wärmesenke (11) verbunden und in der Reihenordnung abwechselnd die ersten und dritten Leiterstücke (19,20) der aufeinanderfolgenden Thermoelemente einander zugewandt sind,
**dadurch gekennzeichnet,**
**dass** die in der Reihenanordnung einander zugewandten Leiterstücke jeweils elektrisch mit einander verbunden und die zweiten Leiterstücke (1;2) abwechselnd durch einen p-leitenden (1) und einen n-leitenden (2) Halbleiter gebildet sind.

2. Vorrichtung nach Anspruch 1,
**dadurch gekennzeichnet,**
**dass** die ersten und dritten Leiterstücke durch Folien (19,20) oder/und Platten gebildet und die Halbleiter (1,2) jeweils an einander gegenüberliegenden Kontaktflächen mit den Folien (19,20) bzw. Platten verbunden sind und eine Stapelanordnung (6) solcher Folien (19,20) oder Platten gebildet ist.

3. Vorrichtung nach Anspruch 2,
**dadurch gekennzeichnet,**
**dass** die einander gegenüberliegenden ersten und dritten Leiterstücke jeweils direkt durch eine, vorzugsweise einzige, mit der Wärmequelle bzw. -senke verbundene Wärmeleitplatte gebildet sind oder dass die Folien (19,20) oder Platten jeweils gegen eine solche Wärmeleitplatte (13,14) anliegen.

4. Vorrichtung nach Anspruch 3,
**dadurch gekennzeichnet,**
**dass** zwischen den Folien (19,20) oder Platten jeweils eine Vielzahl von n-leitenden bzw. p-leitenden Halbleitern (1,2) angeordnet ist.

5. Vorrichtung nach Anspruch 3 oder,
**dadurch gekennzeichnet,**
**dass** die Wärmeleitplatten (13,14) an einem aus der Stapelanordnung (6) vorstehenden Rand mit der Wärmequelle (9) bzw. Wärmesenke (11) im Wärmekontakt stehen.

6. Vorrichtung nach Anspruch 5,
**dadurch gekennzeichnet,**
**dass** das Medium parallel zur Oberfläche der Wärmeleitplatten (13,14) strömt.

7. Vorrichtung nach einem der Ansprüche 3 bis 6,
**dadurch gekennzeichnet,**
**dass** die Wärmeleitplatten (13,14), ggf. in der Art von Heatpipes, von einem wärmetransportierenden Medium durchflossen sind.

8. Vorrichtung nach einem der Ansprüche 3 bis 7,
**dadurch gekennzeichnet,**
**dass** die Wärmequelle (9) und Wärmesenke jeweils einen von einem wärmezu- bzw. -abführendem Medium durchströmten Behälter (9,11) umfasst, in welchen die betreffenden Wärmeleitplatten (13,14) hineinragen.

9. Vorrichtung nach Anspruch 7 oder 8,
**dadurch gekennzeichnet,**
**dass** der in den Behälter (9,11) ragende Teil (15) der Wärmeleitplatte (13,14) elektrisch gegen das Medium isoliert ist.

10. Vorrichtung nach einem der Ansprüche 6 bis 9,
**dadurch gekennzeichnet,**
**dass** zwischen der Stapelanordnung (6) und den Behältern (9,11) eine thermisch und elektrisch isolierende Schicht (7,8) angeordnet ist.

11. Vorrichtung nach einem der Ansprüche 1 bis 10,
**dadurch gekennzeichnet,**
**dass** die Wärmequelle oder Wärmesenke die Wärmeleitplatten (13a) umwindende Röhren (22) umfasst.
